(19) **Europäisches Patentamt**

**European Patent Office**

**Office européen des brevets**

(11) **EP 1 032 870 B1**

(12) **EUROPEAN PATENT SPECIFICATION**

(45) Date of publication and mention
of the grant of the patent:
**24.03.2004 Bulletin 2004/13**

(51) Int Cl.⁷: **G06F 11/20**, G11C 29/00

(21) Application number: **98962738.5**

(86) International application number:
**PCT/RU1998/000392**

(22) Date of filing: **23.11.1998**

(87) International publication number:
**WO 1999/027431 (03.06.1999 Gazette 1999/22)**

(54) **A MEMORY REDUNDANCY ALLOCATION SYSTEM AND A METHOD OF REDUNDANCY ALLOCATION**

VORRICHTUNG UND VERFAHREN ZUR REDUNDANZ-ZUORDNUNG BEI EINEM SPEICHER

SYSTEME D'ALLOCATION PAR REDONDANCE DE MEMOIRE ET PROCEDE D'ALLOCATION PAR REDONDANCE

(84) Designated Contracting States:
**DE GB**

(30) Priority: **21.11.1997 GB 9724529**

(43) Date of publication of application:
**06.09.2000 Bulletin 2000/36**

(73) Proprietor: **Acuid Corporation (Guernsey) Limited**
**St. Peter Port, Guernsey GY1 4HP (GB)**

(72) Inventors:
• **YELKHIMOVA, Juliya Vladimirovna**
**St.Petersburg, 197136 (RU)**
• **DEAS, Alexander, Roger**
**Edinburgh EH22 1JW (GB)**

(56) References cited:
• **HASAN N ET AL: "MINIMUM FAULT COVERAGE IN RECONFIGURABLE ARRAYS" INTERNATIONAL SYMPOSIUM ON FAULT TOLERANT COMPUTING SYSTEMS. (FTCS), TOKYO, JUNE 27 - 30, 1988, no. SYMP. 18, 27 June 1988 (1988-06-27), pages 348-353, XP000676061 INSTITUTE OF ELECTRICAL AND ELECTRONICS ENGINEERS**
• **LOW C -P ET AL: "MINIMUM FAULT COVERAGE IN MEMORY ARRAYS: A FAST ALGORITHM AND PROBABILISTIC ANALYSIS" IEEE TRANSACTIONS ON COMPUTER AIDED DESIGN OF INTEGRATED CIRCUITS AND SYSTEMS, vol. 15, no. 6, 1 June 1996 (1996-06-01), pages 681-690, XP000630124 ISSN: 0278-0070 cited in the application**

# EP 1 032 870 B1

**Description**

<u>Technical field</u>

The present invention relates to a system and a method for searching for a repair solution for a memory device. The proposed invention provides means for searching for a repair solution assuming the availability of unlimited spare resources and adapting the repair solution obtained to an existing ratio of spare resources. The invention is applicable for different manufacturing processes of solid state memories, including semiconductor, ferro-electric, optical, holographic, molecular and crystalline atomic memories.

The present invention is applicable in particular, though not exclusively, to hardware allocation of redundant cells (called spares) to replace faulty cells in memory chips.

<u>Background of the invention</u>

In the memory industry, memory products are tested after fabrication. One approach to maintaining acceptable production yields is the addition of redundant cells that can be used to replace faulty cells. Commonly, redundant structures are fabricated either within or alongside the memory product. Redundancy analysers identify the location of any defects in the product at a level of granularity at least equal to the granularity of the redundant structures, and through a process of redundancy allocation, these redundant structures are configured to map out the defective areas in the main memory.

The size and density of memory products has increased exponentially over time: from $2^{10}$ bits in 1971 to more than $2^{28}$ bits being sampled by manufacturers today. As the density of memory chips increases, the total number of defects also increases, and more redundancy is needed to increase yields. However, too much redundancy is expensive; it increases a die size and reduces the number of dies per wafer. Additionally, the speed of these memories has increased with each generation. Means that were previously adequate for redundancy analysis become too slow or inaccurate in this new environment and often fail to achieve the repair solution even if it exists.

Known are two classes of redundancy allocation systems. One class, e.g. described by Sy Yen Kuo and W. Kent Fuchs in "Efficient Spare Allocation for Reconfigurable Arrays", IEEE Design & Test, February, 1987, pp. 24-31, includes means providing comprehensive approaches, in which many or all potential solutions are examined to select the best feasible. This means uses a tree search method, but this is very slow. The second class (see., i.e. Wei Kang Huang, Yi-Nan Shen and Fabtrizio Lombardi "New Approaches for the Repair of Memories with Redundancy by Row/ Column Deletion for Yield Enhancement, IEEE Transactions on Computer-Aided Design, Vol.9, No.3, March, 1990) offers once-through approximations, such as the industry-wide Most Repair, able to generate a solution very rapidly, but sometimes failing to find a solution when one exists. The penalty for this kind of failure is a loss of yield by the integrated circuit manufacturer.

M. Chester and S. Michaelson in "An Intelligent Algorithm for Redundancy Analysis", J990 Series Redundancy Analyzer's User's Manual, TERADYNE Inc., May 1994, (see also, US 5,795,797 and EP 0845122) described one of the systems used in the industry for increasing the efficiency of once-through methods with the use of a scheduling means controlling the distribution of spare resources. The known system uses a means capable of taking into account, at every repair stage, the balance between supply and demand parameters, i.e. scheduling the allocation of spares, determining which part of the memory has the more pressing demands and which one has sufficient supplies to meet those demands. Such a means, called a scheduling means, determines also how to divide the area of the die into separately treatable areas. Another means, called an allocation means, is capable of analyzing the distribution of defects and spares and allocating the spares to achieve the repair solution. This system represents merely a modification of a classical method. Though it may prove to be successful for simple fail patterns, in the case of high region complexity, such a system reveals the same drawbacks as those discussed above, giving a sub-optimal solution.

<u>Disclosure of the invention</u>

It is an object of the present invention as defined by the independent claims to overcome at least some of the above drawbacks of the prior art by obtaining the minimum repair solution for a memory device.

One aspect of the present invention is a system comprising a scheduling means for maintaining the balanced distribution of spare elements between memory parts to be repaired and an allocating means for searching for a minimum repair solution assuming the availability of unlimited spare resources.

The system creates a repair solution for use by a repair means to repair a memory device formed from physical structures organized into memory parts, each memory part comprising a tile or a group of tiles forming a segment, by allocating spare elements to cover defects existing in the memory device, the system comprising:

a first allocation means operable to receive from a test means addresses of defects and repair all such defect rows in a memory part, in which the number of defects exceeds the number of spare columns available for the memory part, and all such defect columns, in which the number of defects exceeds the number of spare rows available for this memory part,

a second allocation means operable to search for the repair solution for at least one memory part by performing a Minimum Vertex Cover procedure on a bipartite graph derived from the row and column coordinates of all defects assuming the availability of unlimited spare elements to create a solution that uses the minimal amount of spare elements, and, in case the ratio of spares is not appropriate to implement the minimal repair solution, to rearrange this solution using Perfect Cover procedure on the same graph so as to produce either exact solution that uses the same amount of spare resources, or partial solution which may be further adapted by increasing the total amount of spares to use, and

a scheduling means operable to maintain the balanced distribution of spare elements between different memory parts to be repaired by calling the allocation means and rearranging the already allocated spares using the Maximum Matching procedure on a bipartite graph derived from the addresses of defect rows and columns and spare elements available so as to establish the one-to-one correspondence between memory elements to be repaired and spare elements available.

The present invention also provides a method including a step of maintaining the balanced distribution of spare elements between memory parts to be repaired and a step of searching for a repair solution for each part assuming the availability of unlimited spare resources.

Still another aspect of the present invention is a system for treating a memory device formed from physical structures comprising a means for testing a memory device, a means for creating a repair solution by allocating spare elements to cover defects existing in the memory device and a repairing means, wherein the means for creating a repair solution comprises a scheduling means for maintaining the balanced distribution of spare elements between the memory parts to be repaired and an allocation means for searching for a minimum repair solution assuming the availability of unlimited spare elements.

Thus, the invention relates to a system for taking fault information from a memory device and producing an optimal repair solution assuming the availability of unlimited spare resources and then, taking the information about the size, amount and distribution of the actual spare resources in the memory device, under the same conditions, searching for a repair solution using the available resources, starting from the obtained optimal solution. The system comprises a scheduling means (or, a Scheduler) for scheduling the procedure of distribution of spares, and a series of allocation means of varying complexity (which may include, e.g. Easy Repair means, Optimal Repair means, Clever Repair means discussed in detail below, or any other suitable means) which, being called by the scheduling means, solve the problem of allocation of spares among competing segments and tiles. The invention is not limited by using the above means, but may be accomplished in conjunction with the use of industry-wide *Must Repair Means* and others. The system may include a testing means for obtaining fault information about the memory device and a repair means for effecting the repair, such as using a commercial laser repair station, or by programming non-volatile storage locations or by a repair using an Application Specific Integrated Circuit that performs address scrambling or the redirection of addresses.

For a better understanding of the present invention and to show how the same may be carried into effect, reference will now be made, by way of example, without loss of generality, to the accompanying drawings in which:

Fig.1 shows the block scheme of one embodiment of the memory redundancy allocation system according to the invention.

Fig.2 illustrates the primary modes of segmentation used in accordance with the present invention.

Fig.3 shows the flow chart of the allocating means in accordance with the preferred embodiment of the system shown in Fig.1.

Fig.4 shows the flow chart of the first allocation (called Easy Repair) means of the system shown in Fig.1.

Fig.5 shows the flow chart of the Easy Repair procedure for X stripes as part of the flow chart shown in Fig.4.

Fig.6 shows the flow chart of the second allocation (called Optimal Repair) means of the system shown in Fig.1.

Fig.7 shows the flow chart of the third allocation (called Clever Repair) means of the system shown in Fig.1.

Fig.8 shows the flow chart of one of the possible procedures called Clever Repair Find Component procedure used by the Clever Repair Means in accordance with the present invention.

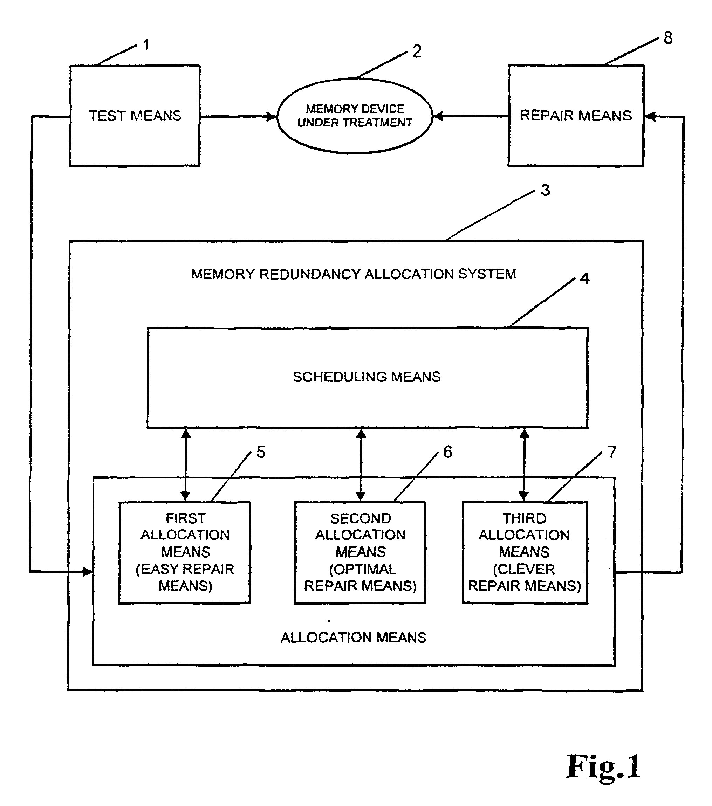

The invention will now be described in detail referring to Fig.1 which represents a system for treating a memory device in accordance with one of the embodiments of the present invention. The system comprises test means 1 for testing a memory device under treatment 2, a memory redundancy allocation system 3 which consists of a scheduling means 4 and an allocation means 5, 6 and 7 and a repair means 8. When the redundancy allocation system 3 receives the fail addresses, which originate in the memory test means 1, and redundancy information, the scheduling means 4 (or, the Scheduler) determines how to divide the memory into separately treatable areas and treats these areas one by one by calling various allocation means 5, 6 or 7 of successively increasing complexity. The industry-wide *Must Repair Means* (see Yen Kuo and W. Kent Fuchs in "Efficient Spare Allocation for Reconfigurable Arrays", IEEE Design & Test, February, 1987, pp. 24-31), or another suitable means optionally may be used instead of or in conjunction with the Easy Repair Means proposed in the present embodiment. The allocation means (or, the Allocator) generates the repair solution for each area. The repair solution is considered to be achieved if sufficient spare resources are allocated to repair all the defects. If the repair solution is not found by using the first allocation means 5, called the Easy Repair means, the scheduling means uses the second allocation means 6, called the Optimal Repair means, to optimize a solution and then, if it fails, turns to the third allocation means 7, called the Clever Repair means. The Clever Repair means 7, on the basis of the data received from means 6, rearranges the optimal solution to adapt it to the existing ratio of spare resources. The corresponding three different types of early abort procedure allow the overall process to be stopped as soon as it is clear that no repair is possible. Upon receipt of the repair solution, repair means 8 repairs the memory device.

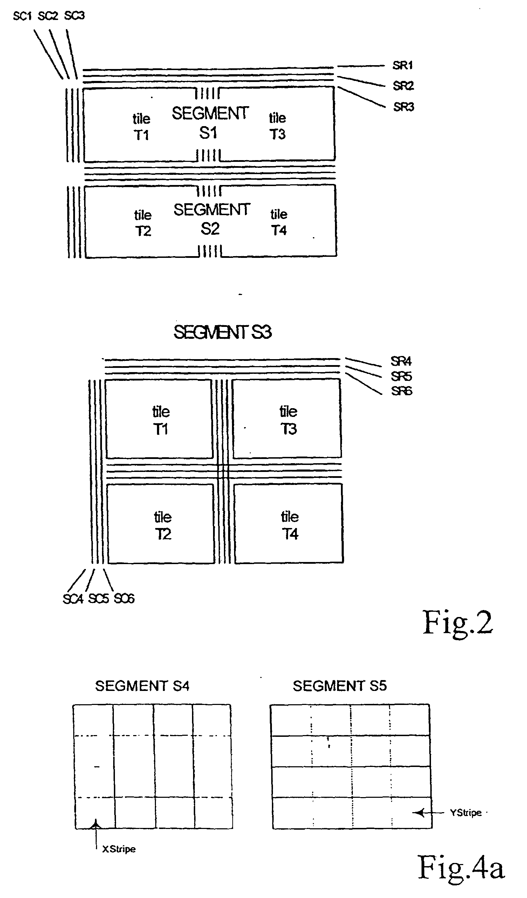

Referring to Fig.2, now examples will be shown of how the memory area may be divided into testable parts according to the present invention. However, these segmentation examples should not be considered as limiting the proposed invention. The system 3 in Fig.1 starts to operate upon receipt of the following information about the memory device: a) the number of memory bits per tile; b) the quantity, distribution and length of spare rows and columns available within the memory. On the basis of this information, the scheduling means divides the area of the memory into separately treatable areas. These areas may be the individual memory arrays known as tiles or groups of tiles combined into segments. Segments are formed when spare rows or columns are more than one tile in length. It shall be mentioned that different types of spare resources and modes of segmentation and various modifications and variations of the proposed system and method of creating a repair solution are possible within the scope of the present invention.

According to the present invention, three types of spare resources are considered, including private, shared and global spare resources. For the purposes of the present description, spare resources that can be applied to repair just one group of adjacent tiles, the group being defined by the length of spare resources, are called private spare resources. Spare resources that are common to a group of tiles, or applicable to the set of groups of adjacent tiles are called shared spare resources. According to a specific memory architecture, for each group of shared spares the set of tile groups in which these spares are applicable, can be defined. Spare resources, i.e. spare rows or columns, available for all tiles in the memory device are called global spare resources.

For example, in Fig.2, SR1 is a private spare row applicable to repair the tile group (T1,T3), i.e. segment S1; SR2 and SR3 are shared spare rows applicable to repair segments S1 and S2, i.e. the tile groups (T1, T3), (T2, T4). Similarly, SC1 is a private spare column applicable to repair the tile T1, while SC2 and SC3 are shared spare columns applicable to repair tiles T1, T3.

Further, SR4 is private spare row applicable to repair tile group (T1, T3); SR5, SR6 - shared spare rows applicable to repair the whole segment S3; SC4 - private spare column applicable to repair tile group (T1, T2); SC5, SC6 - shared spare columns applicable to repair the whole segment S3.

The memory redundancy allocation system 3 in Fig.1 operates as follows. The objective of the scheduling means is to resolve the problem of distribution, i.e. allocation of spares among competing segments and tiles. The Scheduler tries to save the spares that can be most widely used for those situations where no alternative can be found. The Scheduler looks at the defects in each tile (or, segment) and tries to find a sufficient allocation of private spares to supply the resources needed for repairs. If there are insufficient spares of this type, the Scheduler moves on to shared spares, trying to use as few as possible. Taking into account that shared spare resources available to a single tile (or a group of tiles) may not be uniform and can also be used to repair other tile groups, it is important not only to reduce the total number of shared resources used to repair a current tile (or segment), but also to distribute shared spare resources between competing tiles (or segments). To solve these problems, the Scheduler uses a "*Maximum Matching*" procedure described in Hopcroft J., Karp R.M. "An $n^{5/2}$ Algorithm For Maximum Matching In Bipartite Graphs" SIAM J. Comput., 1973, 2, p.p.225-231, that allows to establish the one-to-one correspondence (if any is possible) for the whole memory device between memory cells to be repaired and shared spare resources available.

The Scheduler, using the "*Maximum matching*" procedure, determines the most appropriate shared spare resources and, if necessary, rearranges the resources that are already allocated. Global spares are used as a last resort.

After the tile (or segment) is treated (i.e. it has either been recognized as non-repairable if there are too many defects for the number of available spares or has been allocated sufficient spares), a part or all of its shared resources can be transferred into private spare resources for the tile (or a group of tiles) they are shared with, provided that the tile is the last untreated tile (or a group of tiles) that shares these resources.

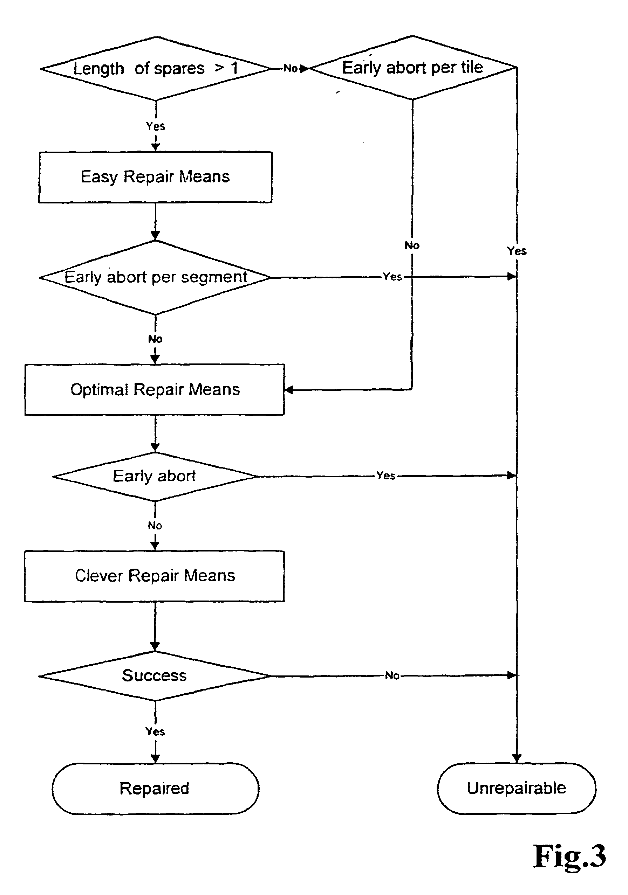

The allocation means (or, the Allocator) finds the minimum repair solution for every segment or tile using preferably a series of successively more complex means 5, 6 and 7, namely the *Easy Repair* Means (or another means, for example a *Must Repair Means),* Optimal Repair Means and Clever Repair Means and by allocating the simplest resource types possible by interaction with the Scheduler. The degree of complexity of the means called reflects the difficulty of the problem the Allocator requires to solve. An example of the operation scheme of the Allocator is described in Fig.3. It is important to mention that the repair solution may be found by using the Allocator in conjunction with another suitable set of allocation means. It shall be noted also that the repair solution found assuming the availability of unlimited spare resources might be in conformity with the existing ratio of available spare resources, and then the step of adapting the optimal solution may be omitted. Any other suitable procedure of finding a minimum vertex cover problem solution may be used instead of Vertex Cover Procedure which is based on the "Maximum Matching" procedure and will be discussed in detail below.

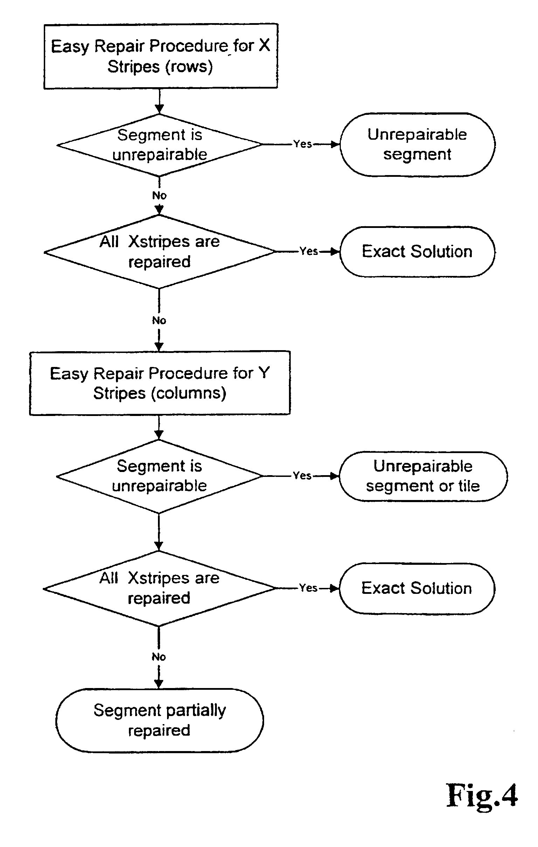

An example of the operation scheme of the first allocation means called Easy Repair means is shown in Fig. 4. In general, for most applications, industry-wide Must Repair means may be used as the Easy Repair means to be applied to the segment. However, in some cases of a simple memory architecture, for example, when the shared spare resources can be applied to repair the adjacent tiles (or groups of tiles only), the following scheme of the operation of the Easy Repair means shown in Fig.4 may be applied.

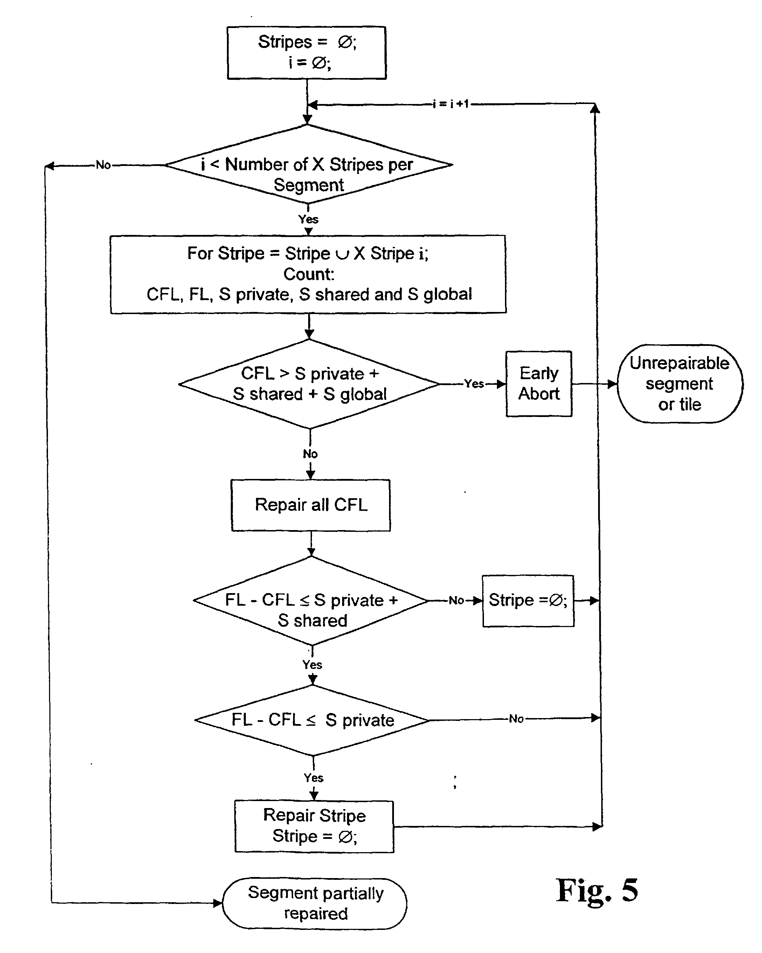

The Easy Repair means repairs all parts of the segment that can be easily repaired either with spare rows or with spare columns and thus maximizes the probability for repair of adjacent tiles and segments. Each segment is divided into groups of adjacent tiles running in an X axis, called X stripes, and of adjacent tiles running in a Y axis, called Y stripes. In Fig. 4a each tile in an X stripe has the same set of spare rows available and each tile in an Y stripe has the same set of spare columns available. An example of the Easy Repair procedure in case of repairing X stripes is shown in Fig. 5.

According to Fig.5, to initiate the procedure of repairing X stripes, the array of stripes is defined and the number of X stripes per segment is given by i. In each step, when i is less than the total number of X stripes, the following data are counted for each stripe:

**CFL** - critical faulty lines, i.e. the number of faulty columns (for X stripes) or rows (for Y stripes) that can be repaired using spare columns (rows) only. The number of defects in these columns (rows) exceeds the number of spare rows (columns) available for the stripe;

**FL** - faulty lines, i.e. the number of columns (for X Stripe) or rows (for Y Stripe) that contain defects;

**S private -** the number of private spare columns (rows) available for this X Stripe (Y stripe) only;

**S shared** - the number of shared spare columns (rows for Y stripes) available for X Stripe (Y Stripe);

**S global** - the number of global spare rows.

When the total number of spare resources defined as S private + S shared + S global, is less than the number of critical faulty columns in Stripe (faulty columns that could be repaired with spare columns only), the procedure is stopped and the segment is marked as unrepairable. Otherwise, all critical faulty columns in X stripes are repaired, and the number of columns in X stripe that contain defects is checked for being less than the sum of the number of private and shared spare resources. Finally, the columns that contain defects that could be repaired using private spare columns only are repaired and the segment is marked as partially repaired.

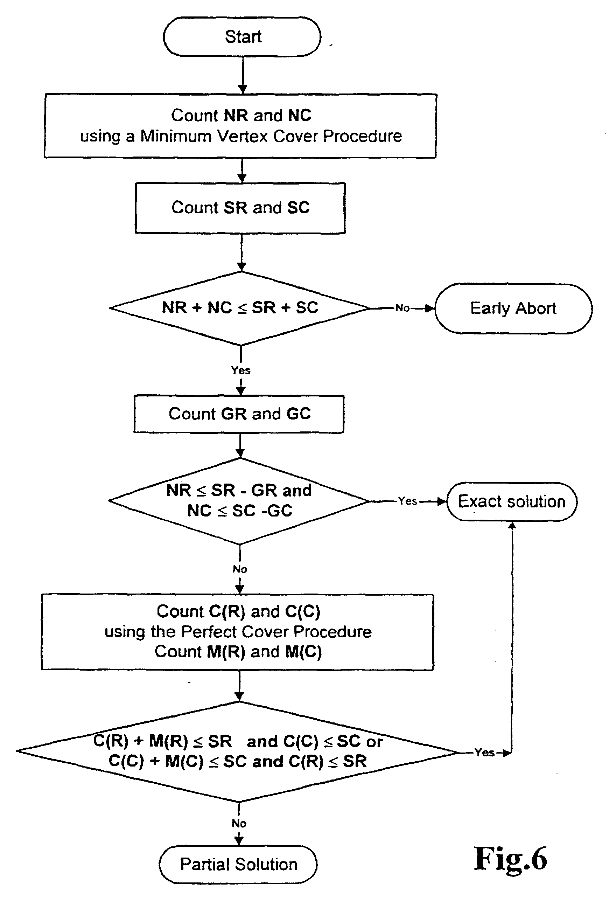

Fig. 6 shows the flow chart of the second allocation means called Optimal Repair means. The Optimal Repair means operates on the basis of a bipartite graph derived from the X and Y coordinates of defects. The Optimal Repair means performs Minimum Vertex Cover procedure to find the exact solution and, if necessary, Perfect Cover procedure to find all possible optimal solutions.

Referring to Fig.6, the operation scheme of the Optimal Repair means will be explained in more detail. At the initial stage of the Optimal Repair means operation, the minimum number of spares necessary for every repair solution for the current tile (or segment) and one of the possible optimal solutions are determined by the Minimum Vertex Cover means. The components shown in Fig. 6 have the following meanings:

**M -** the control set of all the X and Y coordinates of all the defects on the current tile or segment;

**Minimum Vertex Cover** procedure - defines the minimum number of spare columns and rows needed to cover the defects of the current tile or segment;

**NC -** the number of Y-coordinates in M; each Y-coordinate in M corresponds to the Y value of a fault;

**NR -** defines the number of X-coordinates in M; each X-coordinate M corresponds to the X value of a fault;

**NC + NR -** this is equal to the size of maximum matching for the graph; the control set **M** corresponds to one of the possible solutions of the minimum vertex cover problem;

**SR -** the total number of spare rows available;

**SC -** the total number of spare columns available;

**GR -** the number of spare rows shared with other tile groups and the number of global spare rows;

**GC -** the number of spare columns shared with other tile groups and the number of global spare columns.

Using a Minimum Vertex Cover Procedure of finding a solution for a minimum vertex cover problem for a bipartite graph based on the X and Y coordinates of the defects, the number NR of X coordinates in the control set M and the number NC of Y coordinates in the set M are encountered, NR corresponds to the number of spare rows and NC - to the number of spare columns necessary for one of the possible repair solutions.

If the number of spare resources, i.e. the sum of the number of spare rows and the number of spare columns, is less than this critical sufficiency, i.e. the sum of the number of X coordinates in M and the number of Y coordinates in M, then the tile or segment is unrepairable and the process is aborted. If not, and the existing ratio of spare resources satisfies the obtained solution, then an exact solution is definitely available and the problem is considered to be solved.

Otherwise, i.e. if the number of spare resources available is not less than the critical sufficiency, but the existing ratio of spare resources does not satisfy the obtained solution, the Optimal Repair means analyses the bipartite graph using the Perfect Cover Procedure to determine critical sets of rows C(R) and columns C(C), which must be included in the optimal solution, and mighty sets of rows M(R) and columns M(C) that will complement the critical set to cover all the faulty cells such that M(R) n C(R) = $\varnothing$ and M (C) $\cap$ C(C) = $\varnothing$ and the corresponding vertices have at least two adjacent ones. Analyzing these two sets, all the optimal solutions corresponding to the minimum N = NR + NC of spares can be examined. Thus, the optimal solution (if one is possible) may be achieved, i.e. the solution where every defective bit on a tile or segment is matched by a spare row or column and where the minimum number of spare rows and columns is used. If not, i.e. neither condition (A) : C (R) + M(R) $\leq$ SR and C(C) $\leq$ SC nor condition (B): C(C) + M(C) $\leq$ SC and C(R) $\leq$ SR(A) of Fig.6 is fulfilled, then no optimal solution can be achieved using the available ratio of spares. Then this solution is called a *partial solution* and it is implemented to investigate whether the solution is available with the more than minimum N number of spares.

An example of the above Perfect Cover procedure is described by Chor-Ping Low and Hon Wai Leong in "Minimum Fault Coverage in Memory Arrays: A Fast Algorithm and Probabilistic Analysis"; IEEE Transactions on Computer-Aided Design of Integrated Circuits and Systems. Vol. 15, No. 6, June 1996.

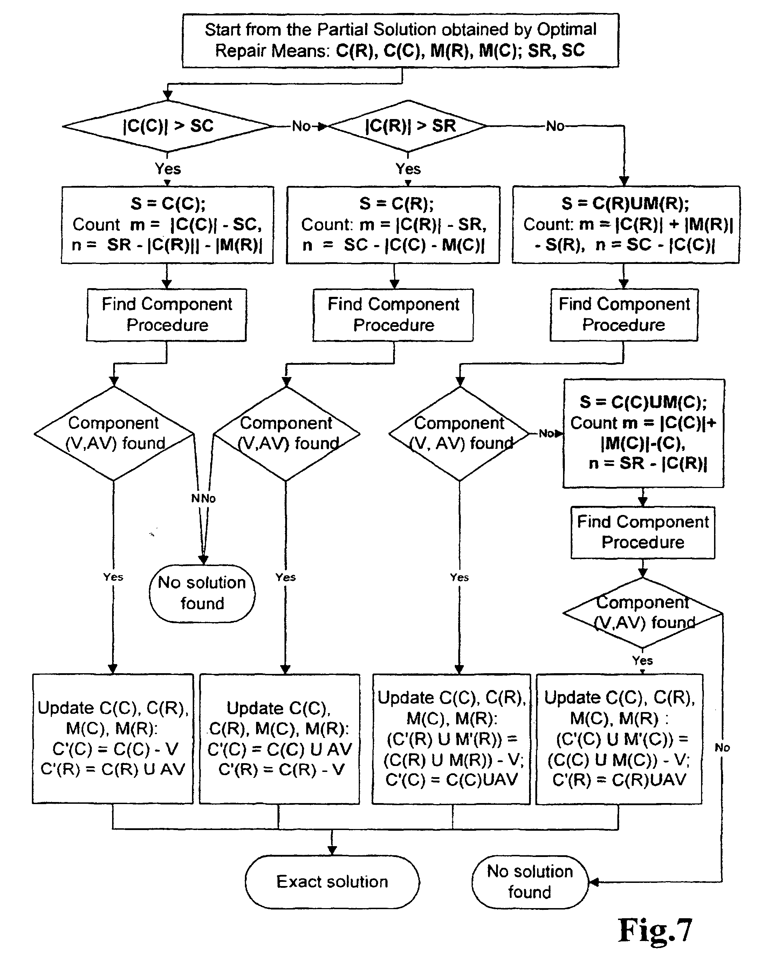

The third allocation means, i.e. the Clever Repair means, is called when the Optimal Repair means produces a *partial solution* and no optimal solution can be achieved. The third allocation means adapts the partial solution to the existing ratio of spare resources. The main goal of Clever Repair is to change the critical and mighty sets in such a way that either condition (A) or condition (B) will be fulfilled. Then the repair solution is obtained with the number of spares that is more than N, but that complies to the given ratio of spare resources. An example of the flow chart of the procedure is shown in Figure 7.

For this purpose, a subset of critical and mighty sets is to be found, the subset being such that its vertices (rows or columns) forming the partial solution may be changed to their adjacent vertices (columns or rows) in such a way as to conform to the existing ratio of spare resources. The assumption is made that, with a high probability, this subset corresponds to the vertices of one of the connected components of the partial solution in the critical and mighty sets and the adjacent vertices. If the Clever Repair means succeeds, the updated critical and mighty sets will satisfy the conditions of the Optimal Repair procedure and the exact solution will be defined.

Now the procedure shown in Fig.7 will be explained in more detail. If Optimal Repair fails and the tile (segment) is not marked as non-repairable, the following condition must be true: |C(C)| > SC or |C(R)| > SR or (|C(C)| + |M(C)| >SC and |C(R)| + |M(R)| > SR). In each of three cases one can count **m**, the minimum number of columns (rows) from the C(C) $\cup$ M (C) (C(R) $\cup$ M(R)) set that need to be changed for the adjacent rows (columns) to satisfy (A) or (B). The maximum number of adjacent rows (columns) that can be used, n, depends on the number of spare rows (columns) available.

If there are no enough spares for the critical sets:

$$|C(C)| > SC \text{ or} \tag{1}$$

$$|C(R)| > SR \tag{2}$$

then **m** : = |C(C)| - SC, **n** : = SR - |C(R)| - |M(R)| or
 **m** : = |C(R)| - SR, **n** : = SC - |C(C)| - |M(C)|, respectively.

If there are no enough spares for both the critical and mighty sets:

$$(|C(C)|+|M(C)|>SC\&|C(R)|+|M(R)|>SR) \tag{3}$$

there are two possibilities:
 **m** : = |C(R)| + |M(R)| - SR, **n** : = SC - |C(C)| or

**m** : = |C(C)| + |M(C)| - SC, **n** : = SR - |C(R)|.

The Clever Repair means resolves the problem of finding the set of vertices V (rows or columns) with the adjacent vertices AV :

$$|V| \geq m, |AV| \leq n, 0 < |RV| - |V| \leq SC + SR - NC - NR. \qquad (4)$$

If the corresponding set (V,AV) is found, the sets C(C), C(R), M(C), M(R) need to be updated according to the following rule:

in the case **(1)** C(C): = C(C)- V and C(R):= C(R) $\cup$ AV;
in the case **(2)** C(C): = C(C) $\cup$ AV and C(R): = C(R) - V;
in the case **(3)** if V corresponds to the rows
(C(R) $\cup$ M(R)):= (C(R) $\cup$ M(R))-V and C(C) :=C(C) $\cup$ AV; otherwise
(C(C) $\cup$ M(C)) : = (C(C) $\cup$ M(C))- V and C(R) : = C(R) $\cup$ AV.

The new C(C), C(R), M(C), M(R) sets will satisfy either condition (A) or condition (B) of Optimal Repair Means and thus, the exact solution with NR + NC - |V| + |AV| rows and columns will be defined.

In the general case, the set V that satisfies (4) may be found as a union of vertices from C(C) $\cup$ M(C) or C(R) $\cup$ M(R) sets but this task is NP-Complete.

The assumption is made that, with a high probability, this set corresponds to the vertices of one of the connected components of the partial solution in the <u>critical</u> and <u>mighty</u> sets (C(C) $\cup$ M(C) or C(R) $\cup$ M(R) and the adjacent vertices).

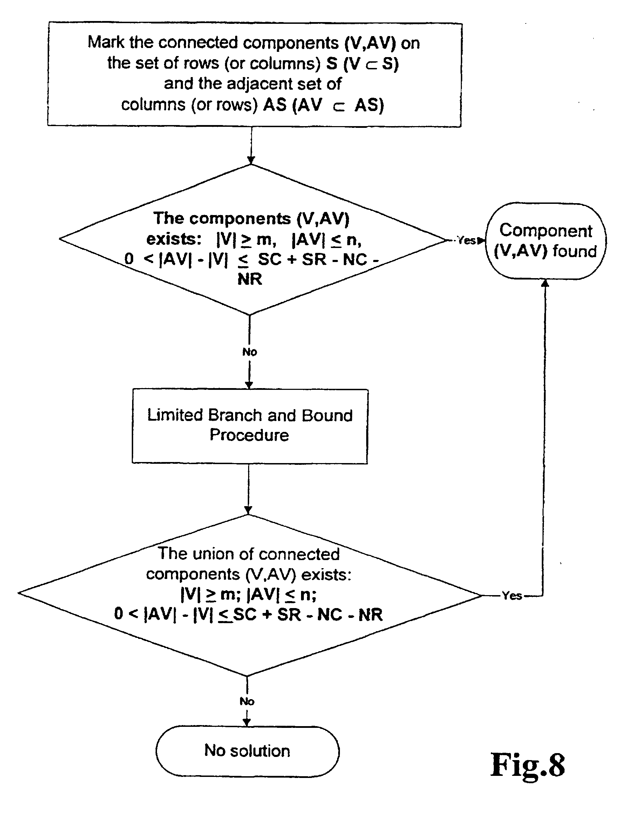

The procedure that finds this subset of vertices is shown in Fig.8. Each vertex from the connected components on the corresponding part of the graph is marked by the pair (V, AV) (<u>Component</u> (V,AV)), where V is the set of vertices from the critical or mighty sets and AV, the set of adjacent vertices. And every vertex V from the critical or mighty sets with its adjacent vertices AV is also marked as Component (V,AV).

Clever Repair Means seeks the Component (V,AV) or the union of a few Components (V,AV) that satisfy (4) and are defined on the set S and the set of adjacent vertices AS:

in the case **(1)** S : = C(C);
in the case **(2)** S : = C(R);
in the case **(3)** S : = C(C) $\cup$ M(C) $\cup$ C(R) $\cup$ M(R).

If no separate Component (V, AV) may be found, all Components (V, AV) are sorted in the |V|/|AV| order and a depth limited Branch and Bound algorithm is applied to find the required Component set.

It will be appreciated that the above is an example embodiment only and that various modifications may be made to the embodiment described above within the scope of the present invention.

**Claims**

1. A system (3) for creating a repair solution for use by a repair means (8) to repair a memory device (2) formed from physical structures organized into memory parts, each memory part comprising a tile or a group of tiles forming a segment, by allocating spare elements to cover defects existing in the memory device, the system comprising:

   a first allocation means (5) operable to receive from a test means (1) addresses of defects and repair all such defect rows in a memory part, in which rows the number of defects exceeds the number of spare columns available for the memory part, and all such defect columns in a memory part, in which columns the number of defects exceeds the number of spare rows available for this memory part,
   and a scheduling means (4) operable to maintain the balanced distribution of spare elements between different memory parts to be repaired,

   ***characterised in that*** the system further comprises
   a second allocation means (6) operable to search for the repair solution for at least one memory part by performing a Minimum Vertex Cover procedure on a bipartite graph derived from the row and column coordinates of all defects assuming the availability of unlimited spare elements to create a solution that uses the minimal amount of spare elements, and, in case the ratio of spares is not appropriate to implement the minimal repair solution, to rearrange this solution using Perfect Cover procedure on the same graph so as to produce either exact solution that uses the same amount of spare resources, or partial solution which may be further adapted by increasing the total amount of spares to use, wherein

the scheduling means (4) maintains the balanced distribution of spare elements between different memory parts to be repaired by calling the allocation means (5, 6) and rearranging the already allocated spares using the Maximum Matching procedure on a bipartite graph derived from the addresses of defect rows and columns and spare elements available so as to establish the one-to-one correspondence between memory elements to be repaired and spare elements available.

2. A system according to claim 1, wherein the first allocation means (5) is further operable to search for the repair solution for at least one tile or a group of tiles forming a linear segment using either only spare columns or only spare rows available for each tile.

3. A system according to any one of claims 1-2, wherein the second allocation means (6) is operable to cover defects that were not allocated spare elements by the first allocation means (5).

4. A system according to any one of claims 1 to 3, further comprising the third allocation means (7) that, under the same condition, adapts the partial repair solution obtained by the second allocation means (6) by changing row and column vertices in the bipartite graph forming a partial solution to their adjacent vertices so as to conform to the existing ratio of available spare elements.

5. A system according to any one of claims 1-4, wherein the scheduling means (4) divides a region of the memory into segments having a size defined by the length of the spare elements and assigns to each segment having defects a required amount of spare elements.

6. A system according to any .one of claims 1-5, **characterised in that** at least one of the allocating means (5, 6, 7) is capable of feedback interaction with the scheduling means (4).

7. A method for treating a memory device formed from physical structures organized into memory parts, each memory part comprising a tile or a group of tiles forming a segment, the method comprising

   a) testing a memory device to find defects existing in the memory device,
   b) creating a repair solution by allocating spare elements to cover these defects, and
   c) physically repairing the memory device by employing spare elements, wherein the operation of creating the repair solution comprises
      a step of receiving from a test means addresses of defects and repairing all such defect rows in a memory part, the number of defects in which exceeds the number of spare columns available for the memory part, and all such defect columns, the number of defects in which exceeds the number of spare rows available for this memory part, and
      a step of maintaining the balanced distribution of spare elements allocated between different memory parts to be repaired,

   **characterised in that** the operation of creating the repair solution further comprises
      a step of performing a Minimum Vertex Cover procedure on a bipartite graph derived from the row and column coordinates of all defects assuming the availability of unlimited spare elements to obtain a solution which uses the minimal amount of spare elements, and, in case the ratio of spares is not appropriate to implement the minimal repair solution, to rearrange the obtained solution using Perfect Cover procedure on the same graph so as to produce either exact solution that uses the same minimal amount of spare elements, or partial solution which may be further adapted, wherein,
      to maintain the balanced distribution of spare elements allocated between different memory parts to be repaired, the obtained solution is further analysed using a Maximum Matching procedure on a bipartite graph to rearrange the already allocated spares so as to establish the one-to-one correspondence between memory elements to be repaired and spare elements available.

8. A method according to claim 7, wherein the first allocation means is further operable to search for the repair solution for at least one tile or a group of tiles forming a linear segment by allocating either only spare columns or only spare rows available for each tile.

9. A method according to any one of claims 7-8, wherein a step of performing a Minimum Vertex Cover procedure is performed to cover defects that were not allocated spare elements on a previous step.

10. A method according to any one of claims 7-9, further comprising a step of adapting the partial repair solution obtained assuming the availability of unlimited spare elements by changing row and column vertices in the bipartite graph forming a partial solution to their adjacent vertices so as to conform to the existing ratio of available spare elements.

11. A method according to claims 7-10, further comprising a step of abort procedure that is carried out after at least one step of searching for the repair solution.

12. A system for treating a memory device formed from physical structures comprising a means for testing a memory device, a system for creating a repair solution by allocating spare elements to cover defects existing in the memory device and a repair means, using the system or method as claimed in any one of claims 1-11.

**Patentansprüche**

1. System (3) zur Erzeugung einer Reparaturlösung zur Verwendung bei einer Reparatureinrichtung (8) zur Reparatur einer Speichereinrichtung (2), die aus in Speicherteilen aufgebauten physikalischen Strukturen besteht, wobei jeder Speicherteil zur Bildung eines Segments eine Teilfläche oder eine Gruppe von Teilflächen umfasst, durch Zuordnen von Ersatzelementen zum Ersetzen von in der Speichereinrichtung bestehenden Defekten, wobei das System umfasst:

eine erste Zuordnungseinrichtung (5), die betreibbar ist zum Empfangen von Adressen von Defekten von einer Prüfeinrichtung (1) und zum Reparieren sämtlicher derartiger defekter Zeilen in einem Speicherteil in den Zeilen, in denen die Anzahl der Defekte die Anzahl der verfügbaren Ersatzspalten für den Speicherteil übersteigt, und sämtliche der defekten Spalten in einem Speicherteil in den Spalten, in denen die Anzahl der Defekte die Anzahl der für diesen Speicherteil verfügbaren Ersatzzeilen übersteigt,

und eine Planungseinrichtung (4), die betreibbar ist zum Aufrechterhalten einer ausgewogenen Verteilung der Ersatzelemente zwischen unterschiedlichen zu reparierenden Speicherteilen,

**dadurch gekennzeichnet, dass** das System ferner umfasst:

eine zweite Zuordnungseinrichtung (6), die betreibbar ist zum Aufsuchen einer Reparaturlösung für zumindest einen Speicherteil mittels Durchführen eines Minimum-Vertex-Cover-Ablaufs mit einem zweiteiligen Graphen, der aus den Zeilen- und Spaltenkoordinaten sämtlicher Defekte abgeleitet ist unter der Annahme der Verfügbarkeit unbegrenzter Ersatzelemente zur Erzeugung einer Lösung, die eine minimale Menge der Ersatzelemente verwendet, und, für den Fall, dass das Verhältnis der Ersetzungen nicht angemessen ist für ein Implementieren der Minimalreparaturlösung, zum Neuanordnen dieser Lösung unter Verwendung eines Perfect-Cover-Ablaufs mit dem selben Graphen zur Bildung entweder einer exakten Lösung, die die gleiche Menge an Ersatzmitteln verwendet, oder einer Teillösung, die des weiteren angepasst werden kann durch Vergrößern der Gesamtmenge der zu verwendenden Ersatzmittel, wobei

die Planungseinrichtung (4) die ausgewogene Verteilung der Ersatzelemente zwischen den unterschiedlichen zu reparierenden Speicherteilen aufrechterhält durch Aufrufen der Zuweisungseinrichtung (5, 6) und Neuanordnen der bereits zugeordneten Ersatzmittel unter Verwendung eines Maximum-Matching-Ablaufs mit einem zweiteiligen Graphen, der aus den Adressen der defekten Zeilen und Spalten und den verfügbaren Ersatzelementen abgeleitet wird zum Erzielen einer Eins-zu-eins-Entsprechung zwischen den zu reparierenden Speicherelementen und den verfügbaren Ersatzelementen.

2. System nach Anspruch 1, wobei die erste Zuweisungseinrichtung (5) des weiteren betreibbar ist zum Aufsuchen der Reparaturlösung für zumindest eine Teilfläche oder eine Gruppe von Teilflächen, die ein lineares Segment bilden, unter Verwendung von entweder lediglich Ersatzspalten oder lediglich Ersatzzeilen, die für jede Teilfläche verfügbar sind.

3. System nach einem der Ansprüche 1 oder 2, wobei die zweite Zuweisungseinrichtung (6) betreibbar ist zum Behandeln von Defekten, denen noch keine Ersatzelemente mittels der ersten Zuweisungseinrichtung (5) zugewiesen wurden.

4. System nach einem der Ansprüche 1 bis 3, ferner mit der dritten Einrichtung (7), die unter den gleichen Bedingungen die mittels der zweiten Zuweisungseinrichtung (6) erhaltene Teilreparaturlösung anpasst durch Ändern der Zeilen- und Spaltenscheitelpunkte in dem zweiteiligen Graphen, die eine Teillösung mit ihren benachbarten Scheitelpunkten bilden, um dem bestehenden Verhältnis verfügbarer Ersatzelemente zu entsprechen.

5. System nach einem der Ansprüche 1 bis 4, wobei die Planungseinrichtung (4) einen Bereich des Speicherns in Segmente mit einer durch die Länge der Ersatzelemente definierten Größe aufteilt und jedem Segment mit Defekten eine erforderliche Menge von Ersatzelementen zuordnet.

6. System nach einem der Ansprüche 1 bis 5, **dadurch gekennzeichnet, dass** zumindest eine der Zuweisungseinrichtungen (5, 6, 7) in der Lage ist, ein rückgekoppeltes Zusammenwirken mit der Planungseinrichtung (4) durchzuführen.

7. Verfahren zur Behandlung einer Speichereinrichtung, die aus in Speicherteilen organisierten physikalischen Strukturen besteht, wobei jeder Speicherteil eine Teilfläche oder eine Gruppe von Teilflächen aufweist zur Bildung eines Segments, und wobei das Verfahren umfasst:

   a) Testen einer Speichereinrichtung zum Auffinden von in der Speichereinrichtung vorhandenen Defekten,

   b) Erzeugen einer Reparaturlösung durch Zuordnen von Ersatzelementen zur Behandlung dieser Defekte, und

   c) physikalisches Reparieren der Speichereinrichtung durch Verwenden der Ersatzelemente, wobei der Ablauf des Erzeugens der Reparaturlösung die Schritte umfasst:

      einen Schritt des Empfangens von Adressen von Defekten von einer Testeinrichtung und des Reparierens sämtlicher dieser defekten Zeilen in einem Speicherteil in dem die Anzahl der Defekte die Anzahl der für den Speicherteil verfügbaren Ersatzspalten übersteigt, und sämtlicher dieser defekten Spalten in dem die darin auftretende Anzahl der Defekte die Anzahl der für diesen Speicherteil verfügbaren Ersatzzeilen übersteigt, und

      einen Schritt des Aufrechterhaltens der ausgewogenen Verteilung der zwischen den unterschiedlichen zu reparierenden Speicherteilen zugewiesenen Ersatzelementen,

   **dadurch gekennzeichnet, dass** der Vorgang des Erzeugens der Reparaturlösung ferner umfasst:

      einen Schritt des Durchführens eines Minimum-Vertex-Cover-Ablaufs mit einem zweiteiligen Graphen, der aus den Zeilen- und Spaltenkoordinaten sämtlicher Defekte abgeleitet wird unter der Annahme der Verfügbarkeit unbegrenzter Ersatzelemente zum Erhalten einer Lösung, die eine minimale Menge der Ersatzelemente verwendet, und in dem Fall, dass das Verhältnis der Ersetzungen nicht für ein Implementieren der Minimalreparaturlösung angemessen ist, des Neuanordnens der erhaltenen Lösung unter Verwendung eines Perfect-Cover-Ablaufs mit demselben Graphen zur Erzeugung entweder einer exakten Lösung, die dieselbe minimale Menge von Ersatzelementen verwendet, oder einer Teillösung, die weiter angepasst werden kann, wobei

      zur Aufrechterhaltung der ausgewogenen Verteilung der zwischen den unterschiedlichen zu reparierenden Speicherteilen zugewiesenen Ersatzelementen die erhaltene Lösung weiter analysiert wird unter Verwendung eines Maximum-Matching-Ablaufs mit5 einem zweiteiligen Graphen zum Neuanordnen der gerade zugewiesenen Ersetzungen zur Bildung einer Eins-zu-eins-Entsprechung zwischen den zu reparierenden Speicherelementen und den verfügbaren Ersatzelementen.

8. Verfahren nach Anspruch 7, wobei die erste Zuordnungseinrichtung ferner betreibbar ist zum Aufsuchen der Reparaturlösung für zumindest eine ein lineares Segment bildende Teilfläche oder eine Gruppe von Teilflächen durch Zuweisen von entweder lediglich Ersatzspalten oder lediglich Ersatzzeilen, die für jede Teilfläche verfügbar sind.

9. Verfahren nach einem der Ansprüche 7 und 8, wobei ein Schritt der Durchführung eines Minimum-Vertex-Cover-Ablaufs durchgeführt wird zum Behandeln der Defekte, denen in einem vorherigen Schritt keine Ersatzelemente zugeordnet wurden.

10. Verfahren nach einem der Ansprüche 7 bis 9, ferner mit einem Schritt des Anpassens der erhaltenen Teilreparaturlösung unter der Annahme der Verfügbarkeit unbegrenzter Ersatzelemente durch Ändern der Zeilen- und Spalten-Scheitelpunkte in dem zweiteiligen Graphen zur Bildung einer Teillösung zu ihren benachbarten Scheitelpunkten zur Übereinstimmung mit dem bestehenden Verhältnis verfügbarer Ersatzelemente.

11. Verfahren nach einem der Ansprüche 7 bis 10 ferner mit einem Schritt eines Abbruchablaufs, der nach zumindest einem Schritt des Suchens für eine Reparaturlösung durchgeführt wird.

12. System zur Behandlung einer aus physikalischen Strukturen gebildeten Speichereinrichtung, mit einer Einrichtung zum Prüfen einer Speichereinrichtung, einem System zum Erzeugen einer Reparaturlösung durch Zuordnen von Ersatzelementen zur Behandlung von in der Speichereinrichtung vorliegenden Defekten und einer Reparatureinrichtung, wobei das System oder das Verfahren gemäß einem der Patentansprüche 1 bis 11 verwendet wird.

## Revendications

1. Système (3) permettant de créer une solution de réparation destinée à être utilisée par un moyen de réparation (8) pour réparer un dispositif de mémorisation (2) formé à partir de structures matérielles organisées en parties de mémoire, chaque partie de mémoire comportant un carreau ou un groupe de carreaux formant un segment, par affectation d'éléments de réserve pour couvrir des défauts existant dans le dispositif de mémorisation, le système comprenant :

un premier moyen d'affectation (5) ayant pour fonction de recevoir de la part d'un moyen de contrôle (1) les adresses de défauts et de réparer toutes ces rangées de défauts dans une partie de mémoire, dans lesquelles rangées le nombre de défauts dépasse le nombre de colonnes de réserve disponibles pour la partie de mémoire, et toutes ces colonnes de défauts dans une partie de mémoire, dans lesquelles colonnes le nombre de défauts dépasse le nombre de rangées de réserve disponibles pour cette partie de mémoire, et
un moyen d'ordonnancement (4) ayant pour fonction de maintenir la répartition équilibrée d'éléments de réserve entre différentes parties de mémoire à réparer,
le système étant **caractérisé en ce qu'**il comprend en outre :

un deuxième moyen d'affectation (6) ayant pour fonction de rechercher la solution de réparation pour au moins une partie de mémoire en effectuant une procédure de Recouvrement de Sommet Minimal sur un graphe double obtenu à partir des coordonnées de rangées et de colonnes de tous les défauts en supposant la disponibilité d'éléments de réserve illimités pour créer une solution qui utilise la quantité minimale d'éléments de réserve et, dans le cas où le rapport des réserves n'est pas approprié à la mise en oeuvre de la solution de réparation minimale, pour réarranger cette solution en utilisant la procédure de Recouvrement Parfait sur le même graphe et, ainsi produire, ou bien une solution exacte utilisant la même quantité de ressources de réserve, ou bien une solution partielle qui peut être encore adaptée par augmentation de la quantité totale de réserves à utiliser,

où le moyen d'ordonnancement (4) maintient la distribution équilibrée d'éléments de réserve entre des parties de mémoire différentes devant être réparées en appelant le moyen d'affectation (5, 6) et en réarrangeant les réserves déjà affectées au moyen de la procédure d'Adaptation Maximale sur un graphe double obtenu à partir des adresses de rangées et de colonnes de défauts et d'éléments de réserve disponibles afin d'établir la correspondance bi-univoque entre les éléments de mémorisation à réparer et les éléments de réserve disponibles.

2. Système selon la revendication 1, où le premier moyen d'affectation (5) a en outre pour fonction de rechercher la solution de réparation pour au moins un carreau ou un groupe de carreaux formant un segment linéaire en utilisant ou bien seulement des colonnes de réserve ou bien seulement des rangées de réserve disponibles pour chaque carreau.

3. Système selon l'une quelconque des revendications 1 et 2, où le deuxième moyen d'affectation (6) a pour fonction de recouvrir des défauts qui ne sont pas des éléments de réserve affectés au moyen du premier moyen d'affectation (5).

**4.** Système selon l'une quelconque des revendications 1 à 3, comprenant en outre un troisième moyen d'affectation (7) qui, dans les mêmes conditions, adapte la solution de séparation partielle obtenue par le deuxième moyen d'affectation (6) en modifiant les sommets de rangées et de colonnes dans le graphe double en formant une solution partielle en leurs sommets adjacents de manière à être conformes au rapport existant des éléments de réserve disponibles.

**5.** Système selon l'une quelconque des revendications 1 à 4, où le moyen d'ordonnancement (4) divise une région de la mémoire en segments ayant une taille qui est définie par la longueur des éléments de réserve et attribue à chaque segment ayant des défauts une quantité voulue d'éléments de réserve.

**6.** Système selon l'une quelconque des revendications 1 à 5, **caractérisé en ce qu'**au moins l'un des moyens d'affectation (5, 6, 7) est en mesure d'effectuer une interaction par réaction avec le moyen d'ordonnancement (4).

**7.** Procédé permettant de traiter un dispositif de mémorisation formé à partir de structures matérielles organisées en parties de mémoire, chaque partie de mémoire comprenant un carreau ou un groupe de carreaux formant un segment, le procédé comprenant les opérations suivantes :

a) contrôler un dispositif de mémorisation afin de trouver des défauts existant dans le dispositif de mémorisation,
b) créer une solution de réparation en affectant des éléments de réserve afin de couvrir ces défauts, et
c) réparer matériellement le dispositif de mémorisation en employant des éléments de réserve, où l'opération de création de la solution de réparation comprend les opérations suivantes :

recevoir de la part d'un moyen de contrôle les adresses de défauts et réparer toutes ces rangées de défauts dans une partie de mémoire, dont le nombre de défauts dépasse le nombre de colonnes de réserve disponibles pour la partie de mémoire, et toutes ces colonnes de défauts, dont le nombre de défauts dépasse le nombre de rangées des réserves disponibles pour cette partie de la mémoire, et maintenir la distribution équilibrée d'éléments de réserve affectés entre des parties de mémoire différentes devant être réparées,

**caractérisé en ce que** l'opération de création de la solution de réparation comprend en outre :

l'opération consistant à effectuer une procédure de Recouvrement de Sommet Minimal sur un graphe double obtenu à partir des coordonnées de rangées et de colonnes de tous les défauts en supposant la disponibilité d'éléments de réserve illimités afin d'obtenir une solution qui utilise la quantité minimale d'éléments de réserve et, dans le cas où le rapport des réserves n'est pas approprié à la mise en oeuvre de la solution de réparation minimale, de réarranger la solution obtenue au moyen de la procédure de Recouvrement Parfait sur le même graphe de façon à produire ou bien une solution exacte qui utilise la même quantité minimale d'éléments de réserve, ou bien une solution partielle qui peut être encore adaptée,

où, pour maintenir la distribution équilibrée d'éléments de réserve affectés entre des parties de mémoire différentes à réparer, la solution obtenue est encore analysée au moyen d'une procédure d'Adaptation Maximale sur un graphe double pour réarranger les réserves déjà affectées afin d'établir la correspondance bi-univoque entre éléments de mémoire à réparer et éléments de réserve disponibles.

**8.** Procédé selon la revendication 7, où le premier moyen d'affectation a en outre pour fonction de chercher la solution de réparation pour au moins un carreau ou un groupe de carreaux formant un segment linéaire en affectant ou bien seulement des colonnes de réserve ou bien seulement des rangées de réserve disponibles pour chaque carreau.

**9.** Procédé selon l'une quelconque des revendications 7 et 8, où l'opération consistant à effectuer une procédure de Recouvrement de Sommet Minimal est effectuée afin de couvrir des défauts auxquels n'étaient pas affectés des éléments de réserve lors d'une opération précédente.

**10.** Procédé selon l'une quelconque des revendications 7 à 9, comprenant en outre les opérations qui consistent à adapter une solution de réparation partielle obtenue en supposant la disponibilité d'éléments de réserve illimités par changement des sommets de rangées et de colonnes dans le graphe double en formant une solution partielle en leurs sommets adjacents de manière à être conformes au rapport existants d'éléments de réserve disponibles.

**11.** Procédé selon l'une quelconque des revendications 7 à 10, comprenant en outre l'opération qui consiste à faire cesser la procédure qui est effectuée après au moins une opération de recherche de la solution de réparation.

**12.** Système permettant de traiter un dispositif de mémorisation formé à partir de structures matérielles comprenant un moyen de contrôle du dispositif de mémorisation, un système permettant de créer une solution de réparation par affectation d'éléments de réserve visant à recouvrir des défauts existants dans le dispositif de mémorisation, et un moyen de réparation qui utilise le système ou le procédé tel que défini dans l'une quelconque des revendications 1 à 11.

Fig.1

Fig.2

Fig.4a

15

**Fig.3**

Fig.4

Fig. 5

```
                        ┌──────────────┐
                        │    Start     │
                        └──────┬───────┘
                               │
                               ▼
        ┌──────────────────────────────────────────────┐
        │              Count NR and NC                  │
        │   using a Minimum Vertex Cover Procedure      │
        └──────────────────────┬───────────────────────┘
                               │
                               ▼
              ┌─────────────────────────────┐
              │       Count SR and SC       │
              └──────────────┬──────────────┘
                             │
                             ▼
                    ╱────────────────╲
                   ╱   NR + NC ≤ SR + SC ╲──── No ───▶ ( Early Abort )
                    ╲────────────────╱
                             │ Yes
                             ▼
              ┌─────────────────────────────┐
              │       Count GR and GC       │
              └──────────────┬──────────────┘
                             │
                             ▼
                    ╱────────────────╲
                   ╱   NR ≤ SR - GR and ╲──── Yes ───▶ ( Exact solution )
                   ╲    NC ≤ SC -GC     ╱
                    ╲────────────────╱
                             │ No
                             ▼
        ┌──────────────────────────────────────────────┐
        │            Count C(R) and C(C)                │
        │    using the Perfect Cover Procedure          │
        │            Count M(R) and M(C)                │
        └──────────────────────┬───────────────────────┘
                               │
                               ▼
              ╱──────────────────────────────────╲
             ╱  C(R) + M(R) ≤ SR   and C(C) ≤ SC or ╲── Yes ──▶ (Exact solution)
             ╲  C(C) + M(C) ≤ SC and C(R) ≤ SR     ╱
              ╲──────────────────────────────────╱
                               │ No
                               ▼
                      ( Partial Solution )
```

$NR + NC \leq SR + SC$

$NR \leq SR - GR$ and $NC \leq SC - GC$

$C(R) + M(R) \leq SR$ and $C(C) \leq SC$ or $C(C) + M(C) \leq SC$ and $C(R) \leq SR$

**Fig.6**

Start from the Partial Solution obtained by Optimal
Repair Means: C(R), C(C), M(R), M(C); SR, SC

|C(C)| > SC — No → |C(R)| > SR — No

Yes | Yes

S = C(C);
Count m = |C(C)| - SC,
n = SR - |C(R)|| - |M(R)|

S = C(R);
Count: m = |C(R)| - SR,
n = SC - |C(C) - M(C)|

S = C(R)UM(R);
Count: m = |C(R)| + |M(R)|
- S(R), n = SC - |C(C)|

Find Component
Procedure

Find Component
Procedure

Find Component
Procedure

Component
(V,AV) found

Component
(V,AV) found

Component
(V, AV) found — No →

S = C(C)UM(C);
Count m = |C(C)|+
|M(C)|-(C),
n = SR - |C(R)|

NNo

No solution
found

Yes | Yes | Yes

Find Component
Procedure

Component
(V,AV) found

Yes

Update C(C), C(R),
M(C), M(R):
C'(C) = C(C) - V
C'(R) = C(R) U AV

Update C(C),
C(R), M(C), M(R):
C'(C) = C(C) U AV
C'(R) = C(R) - V

Update C(C), C(R),
M(C), M(R):
(C'(R) U M'(R)) =
(C(R) U M(R)) - V;
C'(C) = C(C)UAV

Update C(C), C(R),
M(C), M(R) :
(C'(C) U M'(C)) =
(C(C) U M(C)) - V;
C'(R) = C(R)UAV

No

Exact solution

No solution
found

**Fig.7**

Mark the connected components **(V,AV)** on
the set of rows (or columns) **S (V ⊂ S)**
and the adjacent set of
columns (or rows) **AS (AV ⊂ AS)**

The components **(V,AV)**
exists: $|V| \geq m$, $|AV| \leq n$,
$0 < |AV| - |V| \leq SC + SR - NC - NR$

—Yes▶ Component **(V,AV)** found

No

Limited Branch and Bound
Procedure

The union of connected
components (V,AV) exists:
$|V| \geq m$; $|AV| \leq n$;
$0 < |AV| - |V| \leq SC + SR - NC - NR$

—Yes—

No

No solution

**Fig.8**